# EUROPEAN PATENT APPLICATION

(11) **EP 4 607 790 A1**
(43) Date of publication of application: **27.08.2025**
(21) Application number: 23900888.1
(22) Date of filing: 23.10.2023
(51) Int. Cl.: H02S 40/22, H02S 30/00, H02S 40/38, H02S 20/22, H02S 40/34, H01L 31/048, H01L 31/05

(54) **UNIT-BLOCK-TYPE PHOTOVOLTAIC MODULE**

(30) Priority: 07.12.2022 KR 20220169421
(71) Applicant: POSCO Co., Ltd, Pohang-si, Gyeongsangbuk-do 37859 (KR); Research Institute of Industrial Science & Technology, Pohang-si, Gyeongsangbuk-do 37673 (KR)
(72) Inventor: KIM, Youngsu, Pohang-si Gyeongsangbuk-do 37667 (KR); PARK, Saeho, Seoul 06518 (KR); KIM, Arong, Changwon-si Gyeongsangnam-do 51749 (KR); TARK, Sungju, Pohang-si Gyeongsangbuk-do 37664 (KR)
(74) Representative: Nederlandsch Octrooibureau
(86) International application number: PCT/KR2023/016462
(87) International publication number: WO 2024/122868

(57) **Abstract**

A unit-block-type photovoltaic module is disclosed. A unit-block-type photovoltaic module, according to one aspect of the present invention, may be provided, the unit-block-type photovoltaic module comprising: a support part which has a pocket part formed so that an accommodating space is formed therein, and which is provided with coupling parts so as to be coupled on all sides to neighboring unit-block-type photovoltaic modules; a power generation part which is attached to the front surface of the support part so as to generate electricity using solar light; and a heat insulation part which is formed by filling the pocket part with a filling member, wherein the coupling parts are formed so as to extend from the support part so as to be positioned at the outer periphery of the power generation part.

## Description

### [Technical Field]

The present invention relates to a unit-block type photovoltaic module, and more specifically, to a unit-block type photovoltaic module that may be used as an exterior material and an insulation material for a building.

### [Background Art]

Recently, the use of solar power generation facilities that produce electricity using solar energy has been increasingly widespread. Solar cells that utilize solar energy do not use fossil fuels such as coal or oil, but rather use sunlight, which is a pollution-free and infinite energy source, and are thus gaining attention as a new alternative energy source for the future. Currently, solar cells are used to generate electricity for solar power plants, buildings, and automobiles.

In general, solar power generation is a technology that directly produces electricity using solar cells (Photovoltaic: PV). These solar cells are semiconductor devices that convert light energy into electrical energy using the photovoltaic effect, and include two semiconductor thin films, each with a positive (+) polarity and a negative (-) polarity. A number of solar cell cells are connected in series and parallel to generate the voltage and current required by the user, and the user may use the power generated by these solar cells.

Unlike other alternative energy utilization technologies, solar power generation systems have a simple system configuration, and efforts are being actively made to apply the solar power generation systems in the field of building constructions. For example, building attached photovoltaic (BAPV), which attach photovoltaic modules to the rooftop or exterior walls of buildings, and building integrated photovoltaic (BIPV) have been receiving significant attention.

Among these, the most representative example is BIPV, which integrates the existing building materials with solar cells to simultaneously perform a building material function and a power generation function.

However, BIPV products have not yet been standardized, and are produced as custom-made products according to building designs, which makes it difficult to ensure the economic feasibility of BIPV products due to the high unit price per order.

In addition, most products are provided such that the building roof and facade insulation are installed separately and then solar cells are added, which results in a long and complicated construction period.

On the other hand, when used as exterior materials for buildings, solar cell modules have a back sheet on the rear side thereof, and the back sheet is highly flammable and may emit harmful gases in the event of a fire. In addition, an air layer is formed between the solar cell module and the building insulation to provide cooling, but when such a solar cell module is installed on a building facade, it becomes highly dangerous as the chimney effect may cause fire spread in the event of fire.

Accordingly, the Seoul Metropolitan Government recommends using only GtG (glass to glass) type solar cell modules for BIPV products, which use glass instead of a back sheet on the rear side, but glass has a very low heat transfer rate, making it difficult to effectively dissipate the heat accumulated from receiving sunlight.

### [Disclosure]

### [Technical Problem]

A unit-block type photovoltaic module according to an embodiment of the present invention may serve as an exterior material of a building while ensuring insulation and allowing effective dissipating of heat of the module.

A unit-block type photovoltaic module may allow easy fastening on all sides, enabling flexible adaptation to a desired installation area, thereby minimizing unused area.

### [Technical Solution]

According to one aspect of the present invention, a unit-block type photovoltaic module, which includes: a support portion having a pocket portion formed to provide a storage space therein, and a coupling portion configured to allow coupling on all four sides with neighboring unit-block type photovoltaic modules; a power generation portion attached to a front surface of the support portion and configured to generate electricity using solar energy; and an insulation portion formed by filling the pocket portion with a filler member, wherein the coupling portion extends from the support portion and is positioned at an outer periphery of the power generation portion may be provided.

The power generation portion may include a plurality of solar cells repeatedly arranged at a predetermined interval; a film layer provided to cover upper and lower surfaces of the solar cells; a cover window attached to an upper surface of the film layer; and a bus bar connected to the plurality of solar cells.

The cover window may be provided to have a same color as the support portion.

The unit-block type photovoltaic module may further include a junction box provided in the pocket portion and connected to the bus bar with a conductor.

The unit-block type photovoltaic module may further include a first connector and a second connector connected to the junction box by a cable such that positive direct current power and negative direct current power are separated on opposite sides of the junction box and connected to neighboring unit-block type photovoltaic modules.

The support portion may be provided with connecting holes through which portions of the first and second connectors may be exposed to the outside.

The support portion may be formed with a through hole through which the conductor passes, and the through hole may be provided with an insulator that prevents connection between the conductor and the support portion.

The support portion may be provided at a front surface thereof with a seating groove into which the power generation portion may be inserted and attached such that a surface of the power generation portion may be coplanar with a surface of the support portion.

The support portion may include: a base plate formed in a quadrangular shape having a predetermined area; four side plates bent from edges of the base plate; and the coupling portion extending from each of the side plates.

The coupling portion may be provided to be positioned above or below the power generation portion with respect to the power generation portion, and include a pair of fastening portions formed on the side plates facing each other.

The pair of fastening portions may include: a first fastening portion protruding outwardly from one of the side plates facing each other; and a second fastening portion bent to form a fastening groove into which the first fastening portion may be inserted, wherein the second fastening portion may be formed on the side plate opposite to the side plate on which the first fastening portion may be formed.

The first fastening portion or the second fastening portion may include a fixing portion to be fixed to a wall surface of a building through a fastening member.

The support portion may be formed by bending a metal plate having a predetermined rigidity, and the metal plate may be provided to have a thickness of 0.8 mm to 1.5 mm.

### [Advantageous Effects]

The unit-block type photovoltaic module according to an embodiment of the present disclosure can serve as an exterior material of a building while ensuring insulation and allowing effective dissipating of heat of the module.

The unit-block type photovoltaic module according to an embodiment of the present disclosure is manufactured in a standardized size to allow mass production, thus can allow easy facilitation on all sides, enabling flexible adaptation to a desired installation area, thereby minimizing unused area.

In addition, the power generation efficiency of the photovoltaic module can be improved by dissipating heat using a metal plate having high thermal conductivity.

In addition, since there is no space for air cooling between the existing back sheet and the exterior wall and the module, the risk of fire spreading due to the chimney phenomenon can be prevented in advance, and since a power generation portion is provided in a groove of a support portion, fire safety can be ensured.

### [Description of Drawings]

FIG. 1 is an exploded perspective view illustrating a unit-block type photovoltaic module according to an embodiment of the present invention.
FIG. 2 is an assembled perspective view of FIG. 1.
FIG. 3 is a cross-sectional view illustrating a unit-block type photovoltaic module according to an embodiment of the present invention.
FIG. 4 is a view illustrating an example in which a unit-block type photovoltaic module according to an embodiment of the present invention is assembled to a neighboring photovoltaic module.
FIG. 5 is an assembly view of FIG. 4.
FIG. 6 is a view illustrating an example in which a plurality of photovoltaic modules are assembled to a unit-block type photovoltaic module according to an embodiment of the present invention.
FIG. 7 is a cross-sectional view illustrating a modified example of a support portion provided in a unit-block type photovoltaic module according to an embodiment of the present invention.
FIG. 8 is a cross-sectional view illustrating a modified example of a coupling portion provided in a unit-block type photovoltaic module according to an embodiment of the present invention.
FIG. 9 is a view illustrating an assembled state with a neighboring unit-block type photovoltaic module through the coupling portion shown in FIG. 8.
FIG. 10 is a cross-sectional view illustrating a modified example of a support portion provided in the unit-block type photovoltaic module shown in FIG. 8.

### [Modes of the Invention]

Hereinafter, examples of the present invention will be described in detail with reference to the accompanying drawings. The following examples are provided to fully convey the spirit of the present invention to a person having ordinary skill in the art to which the present invention belongs. The present invention is not limited to the examples shown herein but may be embodied in other forms. In order to make the description of the present invention clear, unrelated parts are not shown and, the sizes of components are exaggerated for clarity.

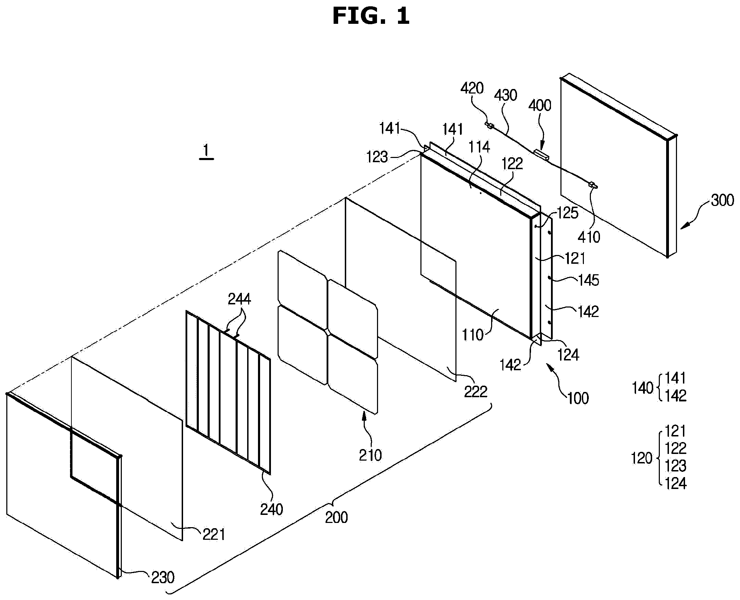

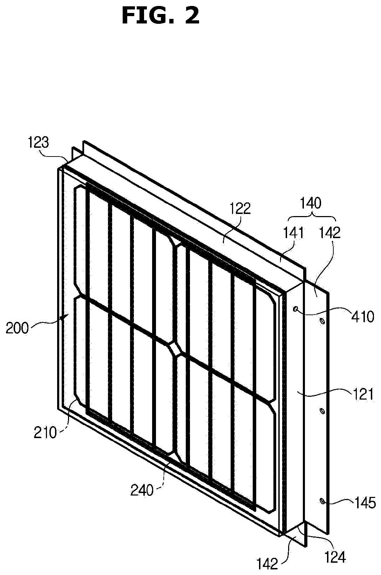

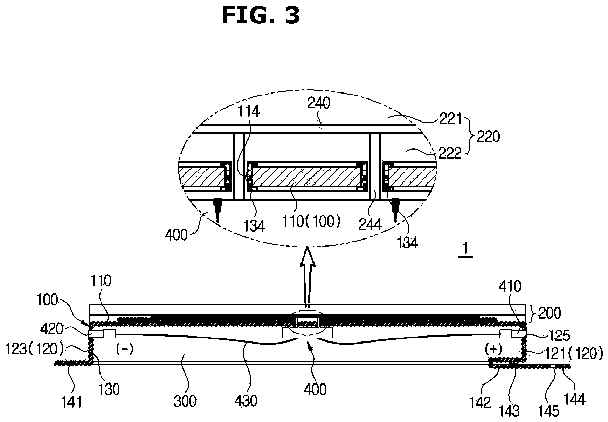

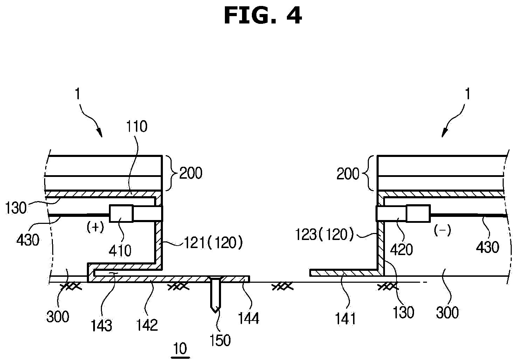

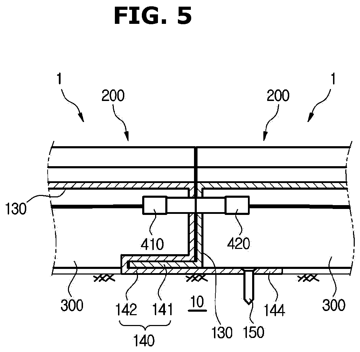

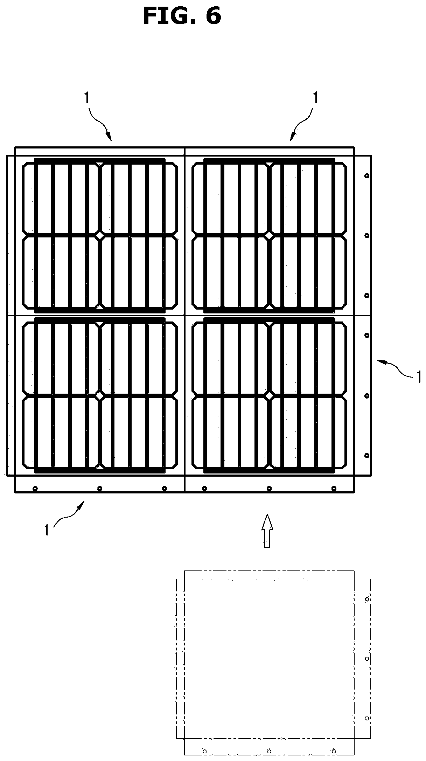

FIG. 1 is an exploded perspective view illustrating a unit-block type photovoltaic module according to an embodiment of the present invention, FIG. 2 is an assembled perspective view of FIG. 1, FIG. 3 is a cross-sectional view illustrating a unit-block type photovoltaic module according to an embodiment of the present invention, FIG. 4 is a view illustrating an example in which a unit-block type photovoltaic module according to an embodiment of the present invention is assembled to a neighboring photovoltaic module, FIG. 5 is an assembly view of FIG. 4, and FIG. 6 is a view illustrating an example in which a plurality of photovoltaic modules are assembled to a unit-block type photovoltaic module according to an embodiment of the present invention.

Referring to FIGS. 1 to 6, a unit-block type photovoltaic module 1 according to one aspect of the present invention may be configured to be used as an exterior material of a building while ensuring insulation. The unit-block type photovoltaic module 1 is manufactured in a standardized size to allow mass production, and may also be provided to allow fastening on all sides to cover the entire façade of a building.

The unit-block type photovoltaic module 1 may include a support portion 100 having a coupling portion 140 provided to allow coupling on all sides with neighboring unit-block type photovoltaic modules 1, a power generation portion 200 attached to a front surface of the support portion 100 to generate electricity using solar energy, and an insulation portion 300 provided in the support portion 100.

The support portion 100 is fixed to a wall surface 10 of a building and serves to support the power generation portion 200, and may be formed by bending a metal plate having a predetermined rigidity. In addition, since the support portion 100 is formed of a metal plate, heat generated from the power generation portion 200 is transferred to the wall surface 10, thereby improving the heat dissipation performance.

In addition, the support portion 100 may be formed of a steel plate, which is a noncombustible material, to prevent burning and emission of harmful gases in the event of a fire. For example, the support portion 100 may be formed of a highly corrosion-resistant steel plate selected from the group consisting of a zinc-plated steel plate, a magnesium-zinc-plated steel plate, a magnesium-zinc-aluminum-plated steel plate, and a stainless steel plate. The steel plate forming the support portion 100 preferably has a thickness of 0.8 mm to 1.5 mm, and more preferably, may be formed to have a thickness of 1.0 mm to 1.2 mm. When the thickness is less than 0.8 mm, durability (strength) as a frame is not ensured, which is not desirable, and when the thickness exceeds 1.5 mm, the weight increases, which is not desirable in terms of weight reduction.

In addition, since the support portion 100 serves as an exterior material of the building, the support portion 100 may be formed of a steel plate capable of expressing texture and color to enhance the aesthetic appearance.

The support portion 100 may be provided to have a pocket portion 130 such that an accommodation space is formed therein. More specifically, the support portion 100 may include a base plate 110, side plates 120 bent from the edges of the base plate 110, and coupling portions 140 extending from the side plates 120. That is, the support portion 100 may be provided with one side open by the base plate 110 and the side plates 120, to form the pocket portion 130.

The base plate 110 may be provided in a quadrangular shape having a predetermined area. The base plate 110 may have the power generation portion 200 attached to a front surface thereof, thereby serving as a substrate of the power generation portion 200.

The side plates 120 may be formed on the edges of the base plate 110 having a quadrangular shape, and thus provided as four side plates. Accordingly, the side plates 120 may be classified into first to fourth side plates 121, 122, 123, and 124 in the order of right, upper, left, and lower directions based on the illustration shown in FIG. 1. That is, among the first to fourth side plates 121 to 124, the first side plate 121 and the third side plate 123 on the right and left sides, and the second side plate 122 and the fourth side plate 124 on the upper and lower sides may be arranged to face each other. It should be understood that the directions described herein are based on the illustration and are not limited thereto, and may vary depending on the viewing direction.

The coupling portion 140 may be formed to extend from each of the four side plates 121 to 124 to thereby be coupled to a neighboring unit-block type photovoltaic module 1. In addition, the coupling portion 140 may include a pair of fastening portions 141 and 142 formed on the side plates 120 facing each other. That is, each pair of fastening portions 141 and 142 may be provided on the first side plate 121 and the third side plate 123, which face each other, as well as the second side plate 122 and the fourth side plate 124, which face each other.

The pair of fastening portions 141and 142 may include a first fastening portion 141 that protrudes outwardly from one of the opposing side plates 120, and a second fastening portion 142 that is bent to form a fastening groove 143 into which the first fastening portion 141 is inserted. In this case, the second fastening portion 142 may be formed on the side plate 120 opposite to the side plate 120 on which the first fastening portion 141 is formed.

For example, when the first fastening portion 141 is formed on the first side plate 121, the second fastening portion 142 may be formed on the third side plate 123. In addition, when the second fastening portion 142 is formed on the first side plate 121, the first fastening portion 141 may be formed on the third side plate 123. Likewise, the second side plate 122 and the fourth side plate 124 may also be optionally provided with the first fastening portion 141 and the second fastening portion 142. Accordingly, through the first fastening portion 141 and the second fastening portion 142 being coupled to each other, continuous coupling with the neighboring unit-block type photovoltaic modules 1 may be achieved.

The first fastening portion 141 or the second fastening portion 142 may include a fixing portion 144 to be fixed to the wall surface 10 of the building through a fastening portion 150. Details of the structure of fixing through the fastening portion 150 and the fixing portion 144 will be described below.

Meanwhile, the coupling portion 140 may be provided to be located below the power generation portion 200 based on the illustration shown in FIG. 3. That is, the first fastening portion 141 and the second fastening portion 142 may be formed to extend from the ends of the side plates 120, which are bent from the base plate 110.

More specifically, the first fastening portions 141 may be formed on the second side plate 122 and the third side plate 123 based on the illustration. The first fastening portions 141 may be bent at and protrude radially outward from the second side plate 122 and the third side plate 123. The first fastening portion 141 may be bent at an angle of 90 degrees to ensure stable coupling with the neighboring unit-block type photovoltaic module 1.

The second fastening portions 142 may be formed on the first side plate 121 and the fourth side plate 124 based on the illustration. The second fastening portion 142 may be bent to form a fastening groove 143 into which the first fastening portion 141 is inserted and coupled. That is, the second fastening portion 142 may be bent a plurality of number of times to form the fastening groove 142 radially inward while having the end thereof protruding radially outward. In this case, it should be understood that the formation position of the fastening groove 142 and the formation position of the first fastening portion 141 are provided coplanar with each other.

Such a pair of fastening portions 141and 142 may not only serve to enable coupling with the neighboring unit-block type photovoltaic modules 1 but also serve as a fixing portion 144 to be fixed to a wall surface 10 of a building. For example, the second fastening portion 142 may be provided with a fixing portion 144 that extends from the end of the second fastening portion 142.

The fixing portion 144 is provided to be in surface contact with the wall surface 10, and has a fastening hole 145 that allows fixing to the wall surface 10 through a fastening portion 150. The fastening portion 150 may be provided as a commonly used fastening portion such as a bolt, a nail, a screw, or a piece.

The power generation portion 200 may be provided to be attached to the front surface of the support portion 100 and generate electricity using solar energy. The power generation portion 200 may include a plurality of solar cells 210, a film layer 220 provided to cover the upper and lower surfaces of the plurality of solar cells 210, a cover window 230 attached to an upper surface of the film layer 220, and a bus bar 240 connected to the plurality of solar cells 210.

The solar cell 210 performs direct current (DC) generation by absorbing energy from incident sunlight through the photoelectric effect, and may be manufactured by joining a positive (P) type semiconductor and a negative (N) type semiconductor. The solar cell 210 generates holes (+) and electrons (-) by the energy of sunlight, and the holes gather toward the P type semiconductor, and the electrons gather toward the N type semiconductor, which causes a potential difference and supplies current to the outside.

The solar cells 210 may be arranged repeatedly at regular intervals, for example, in a grid shape, and may be formed of crystalline silicon, such as single crystal silicon and polycrystalline silicon, or amorphous silicon. In this case, four solar cells 210 are illustrated as being provided in a single unit-block type photovoltaic module 1, but the number, shape, and type of solar cells 210 may be changed depending on the size of the module.

The film layer 220 may be provided to cover the upper and lower surfaces of the solar cell 210. That is, the film layer 220 may be provided as an upper film layer 221 covering the upper surface of the solar cell 210 and a lower film layer 222 covering the lower surface of the solar cell 210. The film layer 220 may be provided as an ethylene-vinyl acetate (EVA) copolymer. The film layer 220 serves to protect the solar cell 210 from external foreign substances and enhance the durability of the solar cell 210.

In addition, when the power generation portion 200 is attached to the front surface of the support portion 100, the upper film layer 221 and the lower film layer 222 may be heated to form a single film layer 220 that encloses the solar cells 210.

The cover window 230 is attached to the upper surface of the film layer 220 and serves to protect the solar cells 210. The cover window 230 may be provided to have a color. For example, the cover window 230 may be provided to have the same color as the support portion 100. Since the cover window 230 is provided to have a color, the solar cell 210 may be concealed without being identified from the outside, thereby enhancing the aesthetic appearance as a building finishing material.

**In** addition, the cover window 230 may be formed of glass or a transparent polymer material.

The bus bar 240 is connected to the solar cell 210. The bus bar 240 is in direct contact with the upper surfaces of the solar cells 210 arranged at the outermost side and is thus connected to the solar cells 240. The bus bar 240 may be connected to a junction box 400 through a conductor 244. In this case, the junction box 400 may be provided in the pocket portion 130, and since the base plate 110 of the support portion 100 serves as a substrate of the solar cell 210, the support portion 110 may have a through hole 114 through which the conductor 244 may pass and connect to the junction box 400. Accordingly, the conductor 244 is connected to the junction box 400 through the through hole 114. In this case, an insulator 134 may be provided to surround the edge of the through hole 114 to prevent a connection between the conductor 244 and the support portion 100.

Meanwhile, since the junction box 400 is provided in the pocket portion 130, the support portion 100 may be provided with a first connector 410 and a second connector 420 such that when connected to neighboring unit-block type photovoltaic modules 1, positive/negative direct current may be separated to provide the connection. For example, the first connector 410 may be connected to the junction box 400 via a cable 430 to be connected to the positive (+) direct current, and the second connector 420 may be connected to the junction box 400 via a cable 430 to be connected to the negative (-) direct current.

The first connector 410 may be connected to a second connector 420 when assembled with the neighboring unit-block type photovoltaic module 1, and the second connector 420 may be connected to a first connector 410. Accordingly, the first connector 410 and the second connector 420 may be installed such that a portion of the first connector 410 and the second connector 420 is exposed to the outside from the support portion 100. That is, connection holes 125 may be formed in portions of the side plates 120 of the support portion 100 in which the first and second connectors 410, 420 are installed, to allow installation of the connectors 410 and 420.

The insulation portion 300 may be formed by filling the pocket portion 130 with a filler. The insulation portion 300 may include insulation materials generally used in buildings, and may be formed of a foamed polystyrene (EPS), polyurethane, and glass wool material that may ensure performances higher than semi-combustible.

As described above, the unit-block type photovoltaic module 1 according to the present invention is provided as a single unit and selectively assembled on all sides, thereby serving as an exterior material of a building while serving as an insulation material.

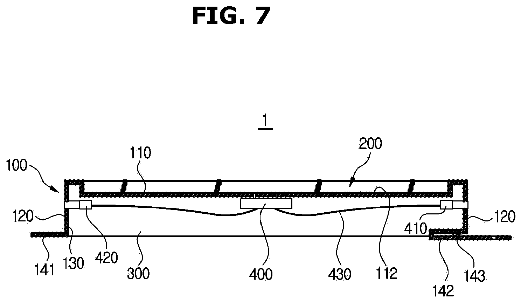

Meanwhile, the unit-block type photovoltaic module 1 is illustrated and described as having the power generation portion 200 attached to the front surface of the base plate 110 of the support portion 100, but the power generation portion 200 may be provided to be seated and attached to the support portion 100 to ensure process convenience, aesthetic quality, and stability. The unit-block type photovoltaic module 1 is illustrated in FIG. 7.

FIG. 7 is a cross-sectional view illustrating a modified example of a support portion provided in a unit-block type photovoltaic module according to an embodiment of the present invention. In the following description, the same reference numerals as those used in the drawings illustrated above indicate members that perform the same functions.

Referring to FIG. 7, the unit-block type photovoltaic module 1 according to the embodiment may further have a seating groove 112 recessed inward from the front surface of the base plate 110 of the support portion 100. That is, the power generation portion 200 may be inserted into and attached to the seating groove 112. In this case, the thickness of the power generation portion 200 and the depth of the fixing groove 112 may be provided to correspond each other. Accordingly, the surface of the power generation portion 200 and the surface of the support portion 100 may be arranged to be coplanar with each other.

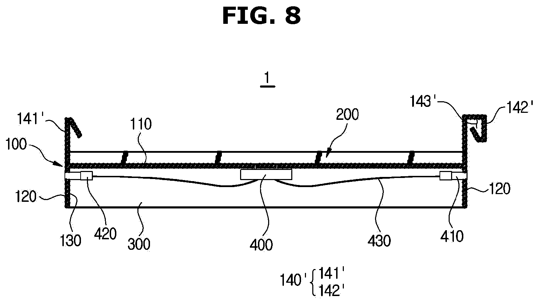

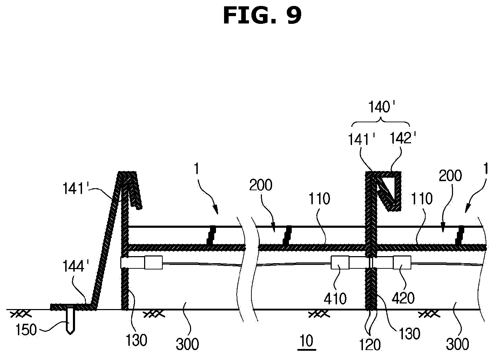

Meanwhile, the unit-block type photovoltaic module 1 is illustrated and described as being assembled laterally when coupled to a neighboring unit-block type photovoltaic module 1, but it is not limited thereto, and may also be assembled longitudinally. The structure of such a unit-block type photovoltaic module 1 is illustrated in FIGS. 8 and 9.

FIG. 8 is a cross-sectional view illustrating a modified example of a coupling portion provided in a unit-block type photovoltaic module according to an embodiment of the present invention, and FIG. 9 is a view illustrating an assembled state with a neighboring unit-block type photovoltaic module through the coupling portion shown in FIG. 8. In the following description, the same reference numerals as those used in the drawings illustrated above indicate members that perform the same functions.

According to the embodiment, the unit-block type photovoltaic module 1 may be provided with a coupling portion to be coupled longitudinally with a neighboring unit-block type photovoltaic module 1.

A coupling portion 140' includes a pair of fastening portions 141'and 142', and the pair of fastening portions 141'and 142' may include a first fastening portion 141' and a second fastening portion 142'. In this case, the coupling portion 140' according to the embodiment may be provided to be located above the power generation portion 200, unlike the previous embodiment.

More specifically, the first fastening portion 141' may be formed to extend upward from the side plate 120 of the support portion 100 and may be bent obliquely from an extended portion of the first fastening portion 141'.

The second fastening portion 142' may be formed to extend upward from the side plate 120, but may be bent to form a fastening groove 143' into which the first fastening portion 141' is inserted. That is, the second fastening portion 142' may be provided to extend upward from the side plate 120 and bent a plurality of number of times such that the first fastening portion 141' may be inserted. In this case, the second fastening portion 142' may be provided with a locking portion that is inclined such that when the first fastening portion 141' is coupled to the second fastening portion 142', an inclined portion of the first fastening portion 141' is engaged with the locking portion to prevent separation.

That is, through the above described pair of fastening portions 141'and 142', the unit-block type photovoltaic modules 1 may be continuously connected in the longitudinal direction and assembled.

Such a pair of fastening portions 141'and 142' not only serves to provide coupling with neighboring unit-block type photovoltaic modules 1, but also serves as a fixing portion 144' to be fixed to the wall surface 10 of the building. For example, it may include a fixing portion 144' that is coupled to the first fastening portion 141' and fixed to the wall surface 10.

The fixing portion 144' may be provided to be coupled to the first fastening portion 141' and be in surface contact with the wall surface 10.The fixing portion 144' may be separately provided, and may be fixed to the wall surface 10 through a fastening portion 150. The fastening portion 150 may be provided as a commonly used fastening component such as a bolt, nail, screw, or piece.

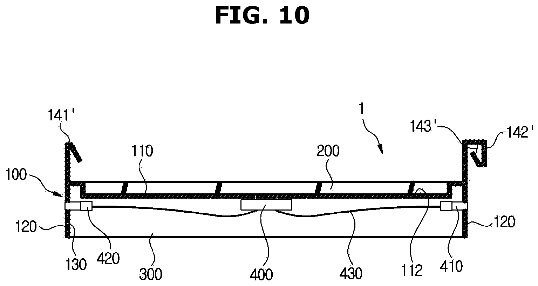

Meanwhile, the unit-block type photovoltaic module 1 according to the embodiment may be provided such that the power generation portion 200 is seated and attached to the front surface of the base plate 110 of the support portion 100 as in the previous embodiment. The unit-block type photovoltaic module 1 is illustrated in FIG. 10.

FIG. 10 is a cross-sectional view illustrating a modified example of a support portion provided in the unit-block type photovoltaic module shown in FIG. 8. In the following description, the same reference numerals as those used in the drawings illustrated above indicate members that perform the same functions.

Referring to FIG. 10, the unit-block type photovoltaic module 1 according to the embodiment may further have a seating groove 112 recessed inward from the front surface of the base plate 110 of the support portion 100. That is, the power generation portion 200 may be inserted into and attached to the mounting groove 112. In this case, the thickness of the power generation portion 200 and the depth of the mounting groove 112 may be provided to correspond to each other. Accordingly, the surface of the power generation portion 200 and the surface of the support portion 100 may be provided to be coplanar with each other.

As described above, the unit-block type photovoltaic module 1, which includes various modified examples, may be used as an exterior material of a building by being coupled to neighboring unit-block type photovoltaic modules 1 in a longitudinal or lateral direction continuously, and ensure insulation performance through the insulation material provided inside.

In addition, by arranging the power generation portion 200 in the seating groove 112 of the support portion 100, not only may the aesthetic appearance be improved, but also the power generation portion 200 may be prevented from being exposed to danger in the event of a fire.

While exemplary embodiments of the present disclosure have been described above with reference to the accompanying drawings, it will be understood by those of ordinary skill in the art that various modifications and changes can be made without departing from the spirit and scope of the present disclosure as defined by the appended claims.

## Claims

1. A unit-block type photovoltaic module comprising:
a support portion having a pocket portion formed to provide a storage space therein, and a coupling portion configured to allow coupling on all four sides with neighboring unit-block type photovoltaic modules;
a power generation portion attached to a front surface of the support portion and configured to generate electricity using solar energy; and
an insulation portion formed by filling the pocket portion with a filler member,
wherein the coupling portion extends from the support portion and is positioned at an outer periphery of the power generation portion.

2. The unit-block type photovoltaic module of claim 1, wherein
the power generation portion includes
a plurality of solar cells repeatedly arranged at a predetermined interval;
a film layer provided to cover upper and lower surfaces of the solar cells;
a cover window attached to an upper surface of the film layer; and
a bus bar connected to the plurality of solar cells.

3. The unit-block type photovoltaic module of claim 2, wherein the cover window is provided to have a same color as the support portion.

4. The unit-block type photovoltaic module of claim 2, further comprising a junction box provided in the pocket portion and connected to the bus bar with a conductor.

5. The unit-block type photovoltaic module of claim 4, further comprising a first connector and a second connector connected to the junction box by a cable such that positive direct current power and negative direct current power are separated on opposite sides of the junction box and connected to neighboring unit-block type photovoltaic modules.

6. The unit-block type photovoltaic module of claim 5, wherein the support portion is provided with connecting holes through which portions of the first and second connectors are exposed to the outside.

7. The unit-block type photovoltaic module of claim 4, wherein the support portion is formed with a through hole through which the conductor passes, and the through hole is provided with an insulator that prevents connection between the conductor and the support portion.

8. The unit-block type photovoltaic module of claim 1, wherein the support portion is provided at a front surface thereof with a seating groove into which the power generation portion is inserted and attached such that a surface of the power generation portion is coplanar with a surface of the support portion.

9. The unit-block type photovoltaic module of claim 1, wherein the support portion includes:
a base plate formed in a quadrangular shape having a predetermined area;
four side plates bent from edges of the base plate; and
the coupling portion extending from each of the side plates.

10. The unit-block type photovoltaic module of claim 9, wherein the coupling portion is provided to be positioned above or below the power generation portion with respect to the power generation portion, and includes a pair of fastening portions formed on the side plates facing each other.

11. The unit-block type photovoltaic module of claim 10,
wherein the pair of fastening portions includes:
a first fastening portion protruding outwardly from one of the side plates facing each other; and
a second fastening portion bent to form a fastening groove into which the first fastening portion is inserted,
wherein the second fastening portion is formed on the side plate opposite to the side plate on which the first fastening portion is formed.

12. The unit-block type photovoltaic module of claim 11, wherein the first fastening portion or the second fastening portion includes a fixing portion to be fixed to a wall surface of a building through a fastening member.

13. The unit-block type photovoltaic module of claim 1, wherein the support portion is formed by bending a metal plate having a predetermined rigidity, and
the metal plate is provided to have a thickness of 0.8 mm to 1.5 mm.
